# EUROPEAN PATENT APPLICATION

(11) **EP 4 765 563 A1**
(43) Date of publication of application: **24.06.2026**
(21) Application number: 25782873.1
(22) Date of filing: 12.02.2025
(51) Int. Cl.: H02J 7/00, G01R 19/10, G01R 19/00, G01R 19/165, H03K 3/037

(54) **BATTERY MANAGEMENT DEVICE AND BATTERY SYSTEM COMPRISING SAME**

(30) Priority: 03.04.2024 KR 20240045174
(71) Applicant: LG Energy Solution, Ltd., Seoul 07335 (KR)
(72) Inventor: SONG, Chang Yong, Daejeon 34122 (KR)
(74) Representative: Plasseraud IP
(86) International application number: PCT/KR2025/002011
(87) International publication number: WO 2025/211568

(57) **Abstract**

A battery management device according to an embodiment disclosed in this document includes an intermediate signal generation unit that generate an intermediate signal related to operation control of a contactor corresponding to each of a first battery pack and a second battery pack connected in parallel with the first battery pack and a final signal generation unit that generates a final signal for controlling an electrical connection of the contactor corresponding to the second battery pack based on a comparison result between a link voltage, which is a voltage applied to nodes to which the first battery pack and the second battery pack are connected by the first battery pack, and a pack voltage applied to a positive contactor corresponding to the second battery pack, and the intermediate signal.

## Description

### TECHNICAL FIELD

### CROSS-REFERENCE TO RELATED APPLICATIONS

This application claims priority from Korean Patent Application No. 10-2024-0045174, filed on April 3, 2024, the disclosure of which is incorporated by reference herein.

### TECHNICAL FIELD

An embodiment disclosed in this document relates to a battery management device and a battery system including the same.

### BACKGROUND ART

Recently, research and development on secondary batteries have been actively conducted. Here, secondary batteries are batteries that can be charged and discharged, and include conventional Ni/Cd batteries, Ni/MH batteries, and recent lithium ion batteries. Among secondary batteries, lithium ion batteries have the advantage of having much higher energy density than conventional Ni/Cd batteries, Ni/MH batteries, etc. In addition, lithium ion batteries may be manufactured to be small and lightweight, and thus the lithium ion batteries are used as a power source for mobile devices. Recently, the scope of use of the lithium ion batteries has expanded to include a power source for electric vehicles, and the lithium ion batteries are attracting attention as a next-generation energy storage medium.

At least one or more battery packs are configured to be connected in series or in parallel to provide a pack voltage to a load. A battery management device may be configured to control an electrical connection between the battery packs and the load, and in particular, in the process of controlling the electrical connection between the battery packs connected in parallel, there is a risk of inrush current occurring as a resistance due to a parallel connection between the battery packs decreases.

### DISCLOSURE OF THE INVENTION

### TECHNICAL PROBLEM

Embodiments disclosed in this document may provide a battery management device that prevents inrush current and a battery system including the same.

The technical problems of the embodiments disclosed in this document are not limited to the technical problems mentioned above, and other technical problems that are not mentioned may be clearly understood by those skilled in the art from the descriptions below.

### TECHNICAL SOLUTION

A battery management device according to an embodiment disclosed in this document may include an intermediate signal generation unit that generates an intermediate signal related to operation control of a contactor corresponding to each of a first battery pack and a second battery pack connected in parallel with the first battery pack and a final signal generation unit that generates a final signal for controlling an electrical connection of the contactor corresponding to the second battery pack based on a comparison result between a link voltage, which is a voltage applied to nodes to which the first battery pack and the second battery pack are connected by the first battery pack, and a pack voltage applied to a positive contactor corresponding to the second battery pack, and the intermediate signal.

According to an embodiment, the final signal generation unit may include a comparator that receives the link voltage and the pack voltage and generates a comparison signal and an SR latch that receives the comparison signal and the intermediate signal and generates the final signal.

According to an embodiment, the comparator may generate a comparison signal in a logic high state when a difference between a voltage level of the link voltage and a voltage level of the pack voltage is less than a preset reference value and generate a comparison signal in a logic low state when the difference between the voltage level of the link voltage and the voltage level of the pack voltage is greater than or equal to the preset reference value.

According to an embodiment, the SR latch may receive an inverted intermediate signal through a set terminal Set and receive the comparison signal through a reset terminal Reset.

According to an embodiment, the SR latch may further include an enable terminal for receiving an enable signal related to a connection of a negative contactor corresponding to the second battery pack, and the enable terminal may receive an enable signal in a logic high state when the negative contactor corresponding to the second battery pack is in a short-circuited state and receive a disable signal in a logic low state when the negative contactor corresponding to the second battery pack is in an open state.

According to an embodiment, the final signal may correspond to an inverted output Q' of the SR latch and the positive contactor corresponding to the second battery pack may be electrically connected in response to the final signal in a logic high state and the intermediate signal in a logic high state.

A battery system according to an embodiment disclosed in this document may include a first battery pack electrically connected to a first node based on a state of a first contactor and electrically connected to a second node based on a state of a second contactor, a second battery pack electrically connected to the first node based on a state of a third contactor and electrically connected to the second node based on a state of a fourth contactor, and a battery management device that controls an operation of the third contactor based on a comparison result between a link voltage voltage applied between the first node and the second node and a pack voltage applied between the third contactor and the second node, in a state where the first battery pack is electrically connected to the first node and the second node and the second battery pack is electrically connected to the second node.

According to an embodiment, the battery management device may include a comparator that receives the link voltage and the pack voltage and an SR latch that receives an output of the comparator to a reset terminal Reset and receives an intermediate signal related to operation control of a third contactor in an inverted state to a set terminal Set.

According to an embodiment, the comparator may output a comparison signal in a logic high state when a difference between a voltage level of the link voltage and a voltage level of the pack voltage is less than a preset reference value and output a comparison signal in a logic high state when a difference between the voltage level of the link voltage and the voltage level of the pack voltage is greater than or equal to the preset reference value.

According to an embodiment, the battery management device may further include an AND gate that receives the intermediate signal and an inverted output Q' of the SR latch and electrically connect the third contactor based on an output of in a logic high state of the AND gate.

According to an embodiment, the intermediate signal may correspond to a logic high state in a case of instructing the third contactor to be short-circuited, and correspond to a logic low state in a case of instructing the third contactor to be opened.

### ADVANTAGEOUS EFFECTS

A battery management device and a battery system including the same according to an embodiment disclosed in this document can prevent the occurrence of inrush current when controlling electrical connection between battery packs connected in parallel.

In addition, various effects can be provided that are directly or indirectly identified through this document.

### BRIEF DESCRIPTION OF THE DRAWINGS

FIG. 1 is a diagram for schematically describing a configuration of a battery system according to an embodiment disclosed in this document.
FIG. 2 is a diagram for describing the configuration of a battery system according to an embodiment disclosed in this document in detail.
FIG. 3 is a diagram for describing a configuration of a final signal generation unit according to an embodiment disclosed in this document.
FIG. 4 is a diagram for describing flows of signals according to the passage of time according to an embodiment disclosed in this document.
FIG. 5 is a diagram for describing a logic state of a final signal according to an embodiment disclosed in this document.

### MODE FOR CARRYING OUT THE INVENTION

Hereinafter, embodiments disclosed in this document will be described in detail with exemplary diagrams. When adding reference numerals to components of each diagram, it should be noted that the same components are given the same reference numerals as much as possible even if they are illustrated in different diagrams. In addition, in describing the embodiments disclosed in this document, when it is determined that a specific description of a related known configuration or function interferes with the understanding of the embodiments disclosed in this document, the detailed description thereof will be omitted.

In describing the components of the embodiments disclosed in this document, the terms first, second, A, B, (a), (b), etc. may be used. These terms are only intended to distinguish the components from other components, and the nature, order, or sequence of the components are not limited by the terms. In addition, unless otherwise defined, all terms used herein, including technical or scientific terms, have the same meaning as generally understood by a person of ordinary skill in the art to which the embodiments disclosed in this document belong. Terms defined in commonly used dictionaries should be interpreted as having a meaning consistent with their meaning in the context of the relevant art, and will not be interpreted in an idealized or overly formal sense, unless expressly defined in this application.

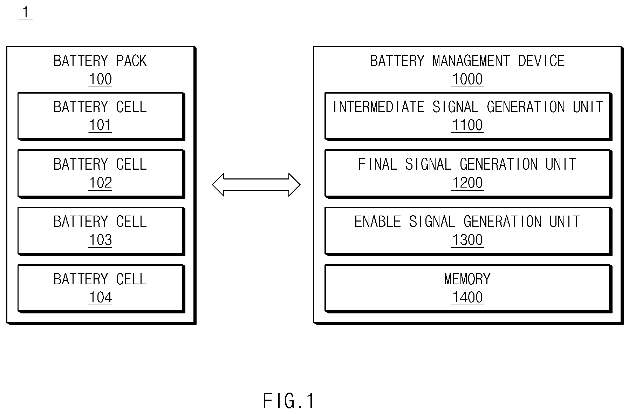

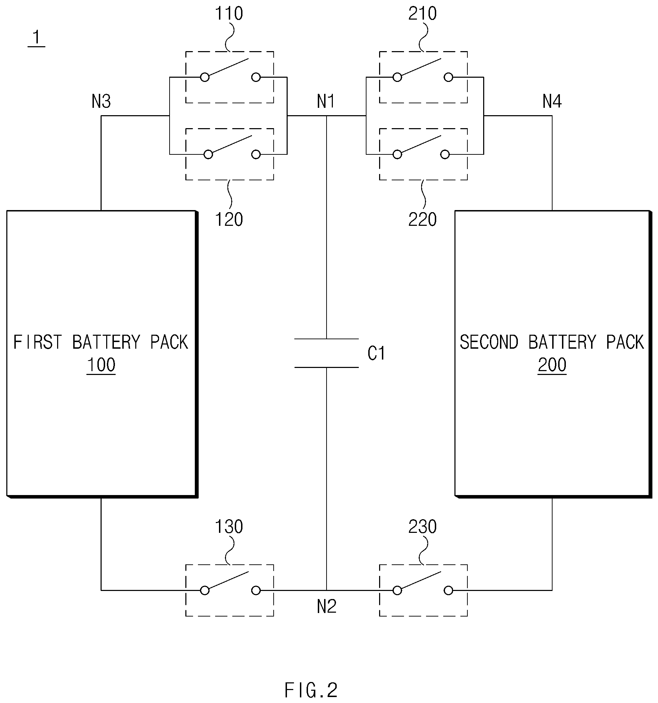

FIG. 1 is a diagram for schematically describing a configuration of a battery system according to an embodiment disclosed in this document, and FIG. 2 is a diagram for describing the configuration of the battery system according to an embodiment disclosed in this document in detail.

First, referring to FIG. 1, a battery system 1 may include a battery pack 100 and a battery management device 1000.

The battery management device 1000 may acquire data related to a state of the battery pack 100 and/or a plurality of battery cells 101, 102, 103, and 104 included in the battery pack 100. For example, the battery management device 1000 may acquire data including at least one of voltage, current, temperature, and resistance of each of the battery pack 100 and/or the plurality of battery cells 101, 102, 103, and 104. To this end, various sensors or various measurement modules not illustrated in FIG. 1 may be additionally installed at arbitrary locations such as the battery pack 100 or a charging/discharging path.

The battery management device 1000 may calculate parameters indicating the state of each of the battery pack 100 and/or the plurality of battery cells 101, 102, 103, and 104, such as a state of charge (SOC) or a state of health (SOH). The battery management device 1000 may calculate parameters based on the state (voltage, current, temperature, resistance, etc.) of each of the battery pack 100 and/or the plurality of battery cells 101, 102, 103, and 104, but is not limited thereto.

The battery management device 1000 may manage and/or control the state and/or operation of the battery pack 100. For example, the battery management device 1000 may manage charging and discharging of the battery pack 100, a plurality of battery modules (not illustrated) included in the battery pack 100, and the plurality of battery cells 101, 102, 103, and 104.

The battery pack 100 may include the plurality of battery cells 101, 102, 103, and 104. In FIG. 1, the battery pack 100 is illustrated as including four battery cells 101, 102, 103, and 104, but is not limited thereto, and the battery pack 100 may be configured to include n (n is a natural number of 2 or more) battery cells.

The battery pack 100 may be configured to supply power to a target device (not illustrated). To this end, the battery pack 100 may be electrically connected to the target device. Here, the target device (not illustrated) may include any electrical, electronic, or mechanical device that operates by receiving power from the battery pack 100, and for example, the target device (not illustrated) may be, but is not limited to, an electric vehicle (EV) or a two-wheeled electric vehicle such as an electric scooter. In addition, when the target device (not illustrated) is a two-wheeled electric vehicle such as an electric scooter, the battery pack 100 mounted on the two-wheeled electric vehicle may be replaceable through a battery swapping station (BSS).

Here, the battery pack 100 may include a battery module (not illustrated) that is not illustrated in FIG. 1 as a unit of a secondary battery including a plurality of battery cells. The battery module (not illustrated) may include a plurality of battery cells, and the battery pack 100 may be configured to include a plurality of battery modules (not illustrated).

Each of the plurality of battery cells 101, 102, 103, and 104 may be a lithium ion (Li-ion) battery, a lithium ion polymer (Li-ion polymer) battery, a nickel cadmium (Ni-Cd) battery, a nickel hydrogen (Ni-MH) battery, or the like, but is not limited thereto. In addition, although the battery system 1 in FIG. 1 is illustrated as including one battery pack 100, the battery system 1 may be configured to include n (n is a natural number of 2 or more) battery packs according to an embodiment. In this case, the plurality of battery packs may be connected in series and/or in parallel.

According to an embodiment, the plurality of battery packs may be connected in parallel. Referring to FIG. 2, the battery system 1 may include a first battery pack 100 and a second battery pack 200 connected in parallel with the first battery pack 100 through a first node N1 and a second node N2.

The first battery pack 100 may be electrically connected to the first node N1 and the second node N2. To this end, the battery system 1 may include a plurality of contactors 110, 120, and 130 that electrically connect the first node N1 and the second node N2 to the first battery pack 100. According to an embodiment, the first battery pack 100 may be electrically connected to the second node N2 based on a state of the first negative contactor 130 corresponding to the first battery pack 100, and may be connected to the first node N1 based on states of the first positive contactor 110 and the first precharge contactor 120 corresponding to the first battery pack 100.

Here, the first negative contactor 130 may be a contactor connecting an anode of the first battery pack 100 and the second node N2 to each other, the first positive contactor 130 may be a contactor connecting a cathode of the first battery pack 100 and the first node N1 to each other, and the first pre-charge contactor 120 may be a contactor connecting the cathode of the first battery pack 100 and the first node N1 to each other to pre-charge the first capacitor C1 before the first battery pack 100 is electrically connected to the first node N1 and the second node N2.

Similarly, the second battery pack 100 may be electrically connected to the first node N1 and the second node N2. To this end, the battery system 1 may include a plurality of contactors 210, 220, and 230 that electrically connect the first node N1 and the second node N2 to the second battery pack 200. According to an embodiment, the second battery pack 200 may be electrically connected to the second node N2 based on the state of the negative contactor 230 corresponding to the second battery pack 200, and may be connected to the first node N1 based on the state of the positive contactor 210 and the precharge contactor 220 corresponding to the second battery pack 200.

Here, the second negative contactor 230 may be a contactor connecting an anode of the second battery pack 200 and the second node N2 to each other, the second positive contactor 230 may be a contactor connecting a cathode of the second battery pack 200 and the first node N1 to each other, and the second pre-charge contactor 220 may be a contactor connecting the cathode of the second battery pack 200 and the first node N1 to each other to pre-charge the first capacitor C1 before the second battery pack 200 is electrically connected to the first node N1 and the second node N2.

Throughout the entire description of this specification, for the convenience of description, description will be made under the assumption that the first positive contactor 110 and the second positive contactor 210 are contactors (positive contactors) that electrically connect the cathodes of the battery packs 100 and 200 and the first node N1 to each other, and the first negative contactor 130 and the second negative contactor 230 are contactors (negative contactors) that electrically connect the anodes of the battery packs 100 and 200 and the second node N2 to each other.

According to an embodiment, a first capacitor C1 may be connected between the first node N1 and the second node N2. The first capacitor C1 may be connected to at least one battery pack, for example, the first battery pack 100 and/or the second battery pack 200, and generate a voltage by the first battery pack 100 and/or the second battery pack 200. Here, the voltage applied between the first node N1 and the second node N2 may be a link voltage.

According to an embodiment, each of the plurality of contactors 110, 120, 130, 210, 220, and 230 may operate in response to the control of the battery management device 1000 (see FIG. 1). The battery management device 1000 may control a connection state of the battery pack 100. For example, the battery management device 1000 may be configured to control the state of each of the plurality of contactors 110, 120, 130, 210, 220, and 230 to a short-circuited state or an open state.

The battery management device 1000 may control the state of each of the plurality of contactors 110, 120, 130, 210, 220, and 230 to electrically connect the first battery pack 100 and/or the second battery pack 200 to the first node N1 and the second node N2 simultaneously and/or electrically connect them at different points in time.

According to an embodiment, the battery management device 1000 may control an operation of the negative contactor to electrically connect the battery pack to the first node N1 and the second node N2. For example, when the first battery pack 100 is connected to the first node N1 and the second node N2 to generate a pack voltage, the battery management device 1000 may control the operation of the first negative contactor 130 so that the first negative contactor 130 corresponding to the first battery pack 100 is short-circuited.

According to an embodiment, when the first negative contactor 130 is short-circuited and the anode of the first battery pack 100 and the second node N2 are electrically connected to each other, the battery management device 1000 may control the operation of the first pre-charge contactor 120. The battery management device 1000 will control the first pre-charge contactor 120 to be in a short-circuited state to pre-charge the first capacitor C1 for a predetermined period of time.

According to an embodiment, after a pre-charge time period ends, the battery management device 1000 may control the operation of the first pre-charge contactor 120 so that the first pre-charge contactor 120 becomes an open state, and control the operation of the first positive contactor 110 so that the first positive contactor 110 becomes a short-circuited state. Since the state of the first negative contactor 130 is maintained in the short-circuited state, the first battery pack 100 may be electrically connected to each of the first node N1 and the second node N2 through the first positive contactor 110 and the first negative contactor 130 in the short-circuited state.

Assuming that the second battery pack 200 is electrically connected to the first node N1 and the second node N2 in a state where the first battery pack 100 is electrically connected to the first node N1 and the second node N2, since the first capacitor C1 is charged with the first battery pack 100 and the link voltage is applied thereto by the first battery pack 100, the pre-charge operation will not be performed when the second battery pack 200 is connected. However, since the same link voltage is applied to the first capacitor C1, if a difference between the voltage applied to the positive contactor 210 of the second battery pack 200 and the link voltage is large, current may flow rapidly to the second battery pack 200. This phenomenon may be an inrush current occurrence phenomenon, and may cause damage to the battery pack 100, 200 and/or the battery management device 1000 due to a sudden increase in the current magnitude.

In order to prevent this inrush current occurrence phenomenon, the battery management device 1000 may control the electrical connection of the contactor 210, 220, and 230 corresponding to the second battery pack 200. Specifically, the battery management device 1000 may generate an intermediate signal for controlling the second positive contactor 210 and the second negative contactor 230, and may generate a final signal for controlling the second positive contactor 210 based on a comparison result between the generated intermediate signal and the second positive contactor 210 and the link voltage.

Hereinafter, for convenience of description, it is assumed that the first battery pack 100 is electrically connected to the first node N1 and the second node N2.

Referring back to FIG. 1, the battery management device 1000 may include an intermediate signal generation unit 1100, a final signal generation unit 1200, an enable signal generation unit 1300, and a memory 1400.

The intermediate signal generation unit 1100 may generate an intermediate signal for controlling the operation of the plurality of contactors 110, 120, 130, 210, 220, and 230. According to an embodiment, the intermediate signal may correspond to an intermediate signal for controlling the state of each of the plurality of contactors 110, 120, 130, 210, 220, and 230. For example, the intermediate signal may be a signal for instructing the plurality of contactors 110, 120, 130, 210, 220, and 230 to be in an electrical short-circuited state and/or an electrical open state.

According to an embodiment, when the intermediate signal instructs each of the plurality of contactors 110, 120, 130, 210, 220, and 230 to be electrically short-circuited, the intermediate signal may correspond to a logic high state. In addition, when the intermediate signal instructs each of the plurality of contactors 110, 120, 130, 210, 220, and 230 to be electrically opened, the intermediate signal may correspond to a logic low state. However, an embodiment disclosed in this document is not limited to this example, and the intermediate signal instructing each of the plurality of contactors to be electrically opened may correspond to a logic high state, and the intermediate signal instructing each of the plurality of contactors to be electrically short-circuited may correspond to a logic low state.

When each of the plurality of contactors 110, 120, 130, 210, 220, and 230 operates only by the control of the intermediate signal generated by the battery management device 1000, the inrush current described with reference to FIG. 2 may occur. Accordingly, the battery management device 1000 may generate a final signal that controls the operation of the plurality of contactors 110, 120, 130, 210, 220, and 230 based on the intermediate signal generated by the intermediate signal generation unit 1100.

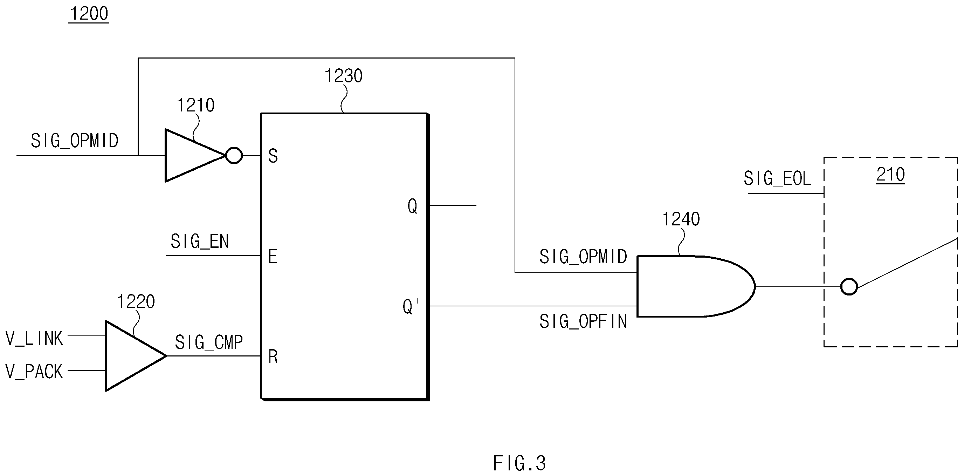

The final signal generation unit 1200 may generate a final signal that controls the operation of the plurality of contactors 110, 120, 130, 210, 220, and 230 based on the intermediate signal. According to an embodiment, the final signal generating unit 1200 may generate a final signal based on the comparison result between the link voltage applied by the first battery pack 100 described with reference to FIG. 2 and the pack voltage applied to the second positive contactor 210 corresponding to the second battery pack 200. The final signal generation unit 1200 may prevent damage to the battery pack due to the occurrence of inrush current by generating a final signal that controls the electrical connection of the positive contactor 220 when the possibility of occurrence of inrush current is low by comparing the link voltage and the pack voltage. Details related to this are described below in the description of FIG. 3.

The enable signal generation unit 1300 may generate an enable signal related to the connection of the negative contactor. According to an embodiment, when the negative contactor corresponding to the battery pack 100 is in an electrically short-circuited state, the enable signal generation unit 1300 may generate and output an enable signal, and when the negative contactor corresponding to the battery pack 100 is in an electrically open state, the enable signal generation unit 1300 may generate and output a disable signal. Here, the enable signal may correspond to a logic high state and the disable signal may correspond to a logic low state, but are not limited thereto.

The memory 1400 may store various data (e.g., commands, voltage of the battery pack, threshold voltage, etc.) for the operation of the battery management device 1000. According to an embodiment, the memory 130 may include, but is not limited to, a volatile memory device such as a static random access memory (SRAM) or a dynamic random access memory (DRAM), or a non-volatile memory device such as a read only memory (ROM), a programmable ROM (PROM), or a flash memory.

According to an embodiment, the battery management device 1000 may be formed integrally with the battery pack 100. In this case, the battery management device 1000 may be implemented as, but is not limited to, a module battery management system (BMS) that controls the overall operation of the battery module (not illustrated) or a pack BMS that controls the overall operation of the battery pack 100.

According to an embodiment, the battery management device 1000 may be formed separately from the battery pack 100. In this case, the battery management device 1000 may be connected to the battery module (not illustrated) and/or the battery pack 100 including the same through a wired and/or wireless network, and the battery management device 1000 may be implemented through various devices such as a cloud server, a charger, or a charger/discharger.

According to an embodiment, the battery management device 1000 may transmit a degradation level (e.g., SOH, etc.) of each of the plurality of battery cells 101, 102, 103, and 104 to an external device (e.g., a cloud server or a user terminal). The cloud server may be configured to provide the degradation level of each of the plurality of battery cells 101, 102, 103, and 104 to a plurality of users, and the user terminal may include a terminal such as a personal computer (PC) or a smartphone, but is not limited thereto.

According to an embodiment, the battery management device 1000 may be implemented through a battery swapping station (BSS). Here, the BSS may be a system having a slot into which the battery pack 100 may be inserted and capable of charging the inserted battery pack 100.

FIG. 3 is a diagram for describing a configuration of a final signal generation unit according to an embodiment disclosed in this document.

Referring to FIG. 3, the final signal generation unit 1200 (see FIG. 1) may include an inverter 1210, a comparator 1220, an SR latch 1230, and an AND gate 1240.

According to an embodiment, the final signal generation unit 1200 may include a plurality of hardware modules. Here, the inverter 1210, the comparator 1220, the SR latch 1230, and the AND gate 1240 may be integrated into one substrate and/or integrated into different substrates.

The inverter 1210 may be configured to invert a logic state of an input signal. According to an embodiment, the inverter 1210 may invert a logic state of an intermediate signal SIG_OPMID generated by the intermediate signal generation unit 1100 (see FIG. 1). For example, when the intermediate signal generation unit 1100 generates an intermediate signal in a logic high state that instructs a contactor to be in an electrical short-circuited state, the inverter 1210 may output a signal in a logic low state, and when the intermediate signal generation unit 1100 generates an intermediate signal in a logic low state that instructs the contactor to be in an electrical open state, the inverter 1210 may output a signal in a logic high state.

According to an embodiment, the inverter 1210 may be electrically connected to a set terminal SET of the SR latch 1230. The inverter 1210 will invert the intermediate signal SIG_OPMID and output it to the set terminal SET.

According to an embodiment, a non-inverted intermediate signal SIG_OPMID may be input to an input terminal of the AND gate 1240.

The comparator 1220 may be configured to output a comparison signal SIG_CMP based on the result of comparing different inputs. According to an embodiment, the comparator 1220 may receive a link voltage and a voltage of a battery pack, and may output the comparison signal SIG_CMP in a different logic state based on the result of comparing the link voltage and the voltage of the battery pack.

According to an embodiment, the link voltage may be a voltage applied between the first node N1 and the second node N2 by the first battery pack 100 described with reference to FIG. 2. In addition, here, the pack voltage may be a voltage applied to the second positive contactor 210 in a state where the second negative contactor 230 is electrically short-circuited and the second positive contactor 210 and the second pre-charge contactor 220 are electrically open. That is, the pack voltage here may be defined as a voltage applied between a fourth node N4 and the second node N2.

When a difference in voltage level between the link voltage and the pack voltage described above is large, the second positive contactor 210 may be electrically short-circuited and at the same time, an inrush current may occur according to the difference in voltage level. The comparator 1220 may output the comparison signal SIG_CMP in a logic high state when a difference between a link voltage V_LINK and a pack voltage V_PACK is less than a preset reference value, and output the comparison signal SIG_CMP in a logic low state when the difference between the link voltage V_LINK and the pack voltage V_PACK is greater than or equal to the preset reference value. Here, the preset reference value may be 1 V, but is not limited thereto, and the reference value may be set and applied in various ways depending on the design.

The comparison signal SIG_CMP output by the comparator 1220 may be input to a reset terminal RESET of the SR latch 1230.

The SR latch 1230 may receive an intermediate signal in an inverted state output by the inverter 1210 as an input to the set terminal S and may receive the comparison signal SIG_CMP output by the comparator 1220 as an input.

The SR latch 1230 may further include an enable terminal E. Here, an enable signal SIG_EN may be input to the enable terminal, and the enable signal SIG_EN may be a signal related to the connection of the negative contactor. According to an embodiment, when the negative contactor is in an electrical short-circuited state, the enable signal SIG_EN in a logic high state may be input to the enable terminal E, and when the negative contactor is in an electrical open state, the enable signal in a logic low state, i.e., a disable signal, may be input to the enable terminal E.

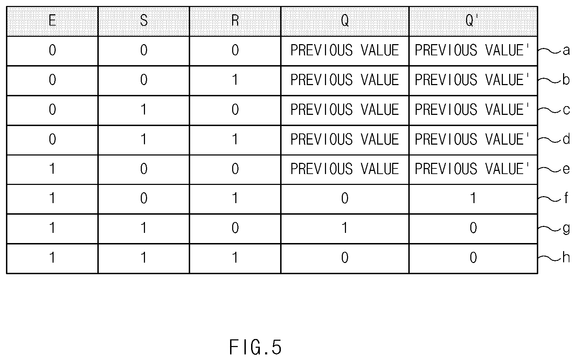

The SR latch 1230 may generate a plurality of outputs based on input signals input through the set terminal S, the reset terminal R, and the enable terminal E. The SR latch 1230 may include a non-inverting terminal Q and an inverting terminal Q'. A truth table related to a plurality of outputs generated by the SR latch 1230 will be described below in the description of FIG. 5.

According to an embodiment, the SR latch 1230 may generate a final signal SIG_OPFIN. Here, the final signal SIG_OPFIN may correspond to an inverted signal output through the inverted terminal Q' of the SR latch 1230, and the final signal SIG_OPFIN may be input to the AND gate 1240.

According to an embodiment, the final signal SIG_OPFIN in a logic high state may be a signal that causes a contactor to be in an electrical short-circuited state, and the final signal SIG_OPFIN in a logic low state may be a signal that causes the contactor to be in an electrical open state. The second positive contactor 210 may be electrically connected in response to the final signal SIG_OPFIN in a logic high state, and may maintain an electrical open state in response to the final signal SIG_OPFIN in a logic low state.

The AND gate 1240 may be electrically connected to the second positive contactor 210 of the second battery pack 200 (see FIG. 2). In FIG. 3, only one positive contactor is illustrated, but is not limited thereto, and it may be electrically connected to the positive contactor of each of the plurality of battery packs included in the battery system 1 (see FIG. 1).

The second positive contactor 210 may operate in response to an output of the AND gate 1240. The second positive contactor 210 may be electrically short-circuited in response to the intermediate signal SIG_OPMID in a logic high state and the final signal SIG_OPFIN in a logic high state.

According to an embodiment, the second positive contactor 210 may include an end of line (EOL) terminal that receives an EOL signal. An EOL signal SIG_EOL input through the EOL terminal may be a signal that forcibly causes the second positive contactor to be in an electrical short-circuited state. When the EOL signal in a logic high state is input, the second positive contactor 210 may be electrically short-circuited regardless of the output of the AND gate 1240.

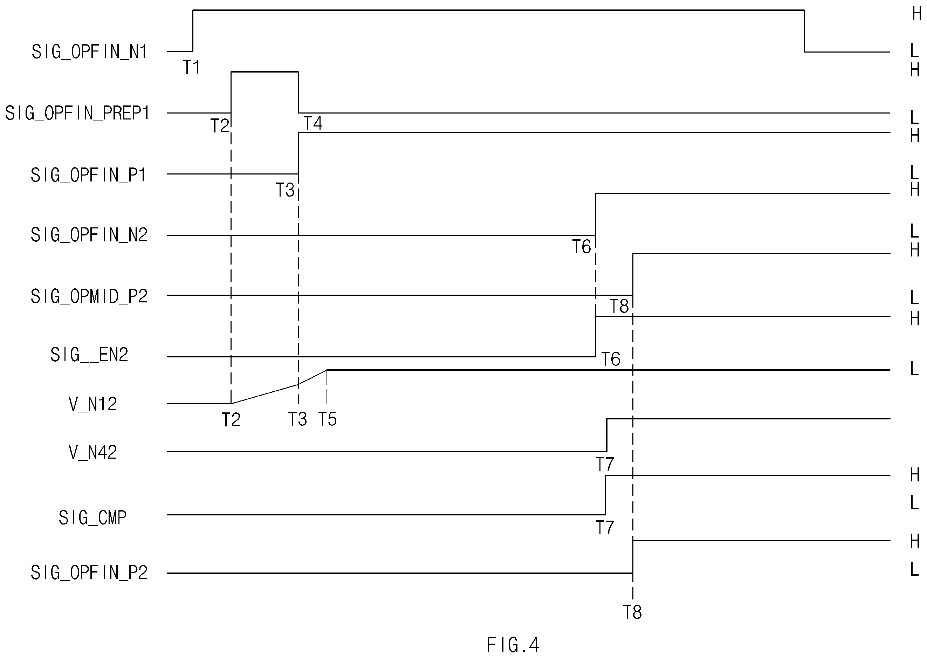

FIG. 4 is a diagram for describing flows of signals according to the passage of time according to an embodiment disclosed in this document.

According to an embodiment, it is assumed that the first battery pack 100 (see FIG. 2) is first electrically connected to the first node N1 (see FIG. 2) and then the second node N2, and the second battery pack 200 (see FIG. 2) connected in parallel with the first battery pack 100 is connected to the first node N1 and the second node N2.

At a time point T1, the battery management device 1000 (see FIG. 1) may output a control signal SIG_OPFIN_N1 that causes the first negative contactor 130 (see FIG. 2) corresponding to the first battery pack 100 to be in an electrical short-circuited state. The first negative contactor 130 may electrically connect the anode of the first battery pack 100 and the second node N2 to each other in response to the control signal SIG_OPFIN_N1 in a logic high state, and the first negative contactor 130 may maintain the electrical short-circuited state until the control signal SIG_OPFIN_N1 becomes a logic low state.

At a time point T2, the battery management device 1000 may output a control signal SIG_OPFIN_PREP1 that causes the first pre-charge contactor 120 corresponding to the first battery pack 100 to be in an electrical short-circuited state. The first pre-charge contactor 120 may pre-charge the first capacitor C1 connected to the first battery pack 100 in response to the control signal SIG_OPFIN_PREP1 in a logic high state.

At a time point T3, the battery management device 1000 may output a first final signal SIG_OPFIN_P1 in a logic high state that controls the operation of the first positive contactor 110 so that the first positive contactor 110 corresponding to the first battery pack 100 is in an electrical short-circuited state. Since other battery packs except for the first battery pack 100 are not electrically connected to the first node N1 and the second node N2 and a pre-charge operation is performed, no inrush current may occur. Therefore, the battery management device 1000 may output the first final signal SIG_OPFIN_P1 that causes the first positive contactor 110 to immediately be in an electrical short-circuited state.

At a time point T4, the battery management device 1000 may output a control signal SIG_OPFIN_PREP1 that causes the first pre-charge contactor 120 corresponding to the first battery pack 100 to be in an electrically open state. The first pre-charge contactor 120 may electrically open the connection between the first battery pack 100 and the first node N1 in response to the control signal SIG_OPFIN_PREP1 in a logic low state.

According to an embodiment, the time points T3 and T4 may be the same time point, or the time point T4 may be earlier than the time point T3.

According to an embodiment, a voltage level of the link voltage V_N12 may gradually increase from the time point T2 when the first capacitor C1 is pre-charged. Here, the first link voltage V_N12 may be a voltage applied between the first node N1 and the second node N2 described with reference to FIGS. 1 and 2.

According to an embodiment, the voltage level of the link voltage V_N12 may rapidly increase from the time point T3 when the first positive contactor 110 corresponding to the first battery pack 100 is electrically short-circuited. The link voltage V_N12 may be saturated at a time point T5, and the link voltage V_N12 at this time point may be a pack voltage of the first battery pack 100.

The battery management device 1000 may electrically connect the second battery pack 200 (see FIG. 2) to the first node N1 and the second node N2 in a state where the first battery pack 100 is electrically connected to the first node N1 and the second node N2 (after the time point T3).

At a time point T6, the battery management device 1000 may output a control signal SIG_OPFIN_N2 that connects the second negative contactor 230 corresponding to the second battery pack 200. The second negative contactor 230 may electrically connect the anode of the second battery pack 200 and the second node N2 to each other in response to the control signal SIG_OPFIN_N2 in a logic high state, and the second negative contactor 230 may maintain an electrical short-circuited state until the control signal SIG_OPFIN_N1 becomes a logic low state.

Since the second negative contactor 230 electrically connects the anode of the second battery pack 200 and the second node N2 at the time point T6, the battery management device 1000 may output an enable signal SIG_EN2 in a logic high state at the time point T6. Here, the enable signal SIG_EN2 may be a signal related to an electrical connection state (e.g., a short-circuited state or an open state) of the second negative contactor 200.

Since the second negative contactor 230 is electrically short-circuited at the time point T6, the voltage level of the pack voltage V_N42 applied to the second positive contactor 210 corresponding to the second battery pack 200 may increase, at a time point T7. Here, the pack voltage V_N42 may be a voltage applied between the fourth node N4 and the second node N2 described with reference to FIG. 2, and the time point T6 and the time point T7 may be the same time point.

According to an embodiment, assuming that a difference in voltage level of each of the pack voltage V_N42 and the link voltage V_N12 after the time point T7 is less than a preset reference value, the battery management device 1000 may output the comparison signal SIG_CMP in a logic high state at the time point T7.

At a time point T8, the battery management device 1000 may generate an intermediate signal SIG_OPMID_P2 for controlling the operation of the second positive contactor 210. At the time point T8, the battery management device 1000 may output the intermediate signal SIG_OPMID_P2 in a logic high state that causes the second positive contactor 210 to be in an electrical short-circuited state.

At the time point T8, the battery management device 1000 may generate a final signal for controlling the operation of the second positive contactor 210. According to an embodiment, since the difference in voltage level between the link voltage V_N12 and the pack voltage V_N42 is less than a preset reference value, the battery management device 1000 may output a final signal SIG_OPFIN_P2 in a logic high state.

From the time point T8, since both the intermediate signal SIG_OPMID_P2 and the final signal SIG_OPFIN_P2 for controlling the second positive contactor 210 are in a logic high state, the second positive contactor 210 may electrically connect the cathode of the second battery pack 200 and the first node N1 to each other in response to the intermediate signal SIG_OPMID_N2 in a logic high state and the final signal SIG_OPFIN_P2 in a logic high state.

FIG. 5 is a diagram for describing a logic state of a final signal according to an embodiment disclosed in this document.

Referring to FIG. 5, examples of non-inverted outputs Q and inverted outputs Q' generated by the SR latch 1230 (see FIG. 3) according to respective inputs are illustrated. Here, '0' may represent a logic low state and '1' may represent a logic high state, but are not limited thereto.

When a signal in a logic high state of 1 is input to the set terminal S and a signal in a logic low state of 0 is input to the reset terminal R the SR latch 1230 may output the signal in the logic high state of 1 through the non-inverting terminal Q and may output the signal in the logic low state of 0 through the inverting terminal Q'.

When a signal of a logic low state of 0 is input to the set terminal S and a signal of a logic high state of 1 is input to the reset terminal R, the SR latch 1230 may output a signal in a logic low state of 0 through the non-inverting terminal Q, and may output a signal in a logic high state of 1 through the inverting terminal Q'.

When a signal of a logic low state of 0 is input to the set terminal S and a signal of a logic low state of 0 is input to the reset terminal R the SR latch 1230 may output a signal in a previous state through the non-inverting terminal Q and the inverting terminal Q'.

According to an embodiment, the SR latch 1230 may further include an enable terminal E, and in this case, the output of the SR latch 1230 described above may be output in synchronization with the enable signal. That is, when an enable signal in a logic low state of 0, i.e., a disable signal, is input through the enable terminal E, the SR latch 1230 may output a signal of a previous state through the non-inverting terminal Q and the inverting terminal Q', and when an enable signal in a logic high state of 1, i.e., an enable signal, is input through the enable terminal E, the SR latch 1230 may output signals in different states based on a logic state of a signal input to the set terminal S and a logic state of a signal input to the reset terminal R.

First, when an enable signal in a logic low state of 0 is input (a to d), both signals output through the non-inverting terminal Q and the inverting terminal Q' of the SR latch may maintain their previous values.

According to an embodiment, when an enable signal in a logic high state of 0 is input (e to h), the SR latch 1230 may output signals through the non-inverting terminal Q and the inverting terminal Q', respectively, based on the logic state of the signal input through the set terminal S and the logic state of the signal input through the reset terminal R.

First, when the comparator 1220 (see FIG. 2) outputs a comparison signal SIG_CMP in a logic high state of 1 (f, h), since the difference in voltage level between the link voltage V_LINK and the pack voltage V_PACK is less than a preset reference value, the possibility of occurrence of inrush current may be low. In this state, when an intermediate signal SIG_MID in a logic high state of 1 is generated to control the second positive contactor 210 to an electrically short-circuited state, the intermediate signal SIG_MID in the logic high state of 1 will be input to the set terminal S in a logic low state of 0 through the inverter 1210, see FIG. 2) (f). Since the SR latch 1230 outputs a signal in a logic high state of 1 through the inverting terminal Q', the second positive contactor 210 may be electrically short-circuited.

In addition, when the comparator 1220 outputs the comparison signal SIG_CMP in the logic low state of 0 (e, g), since the difference in voltage level between the link voltage V_LINK and the pack voltage V_PACK is greater than or equal to a preset reference value, the possibility of occurrence of inrush current may be high. In this state, when the intermediate signal SIG_MID in a logic high state of 1 is generated to control the second positive contactor 210 to an electrically short-circuited state, the intermediate signal SIG_MID in the logic high state of 1 will be input to the set terminal S in the logic low state of 0 through the inverter 1210 (see FIG. 2) (e). In this case, the signals output through the non-inverting terminal Q and the inverting terminal Q' of the SR latch 1230 may maintain the previous values.

Here, when the second positive contactor 210 was in an electrically open state, the SR latch 1230 will output the final signal SIG_OPFIN in a logic low state of 0, and thus the second positive contactor 210 may maintain the electrically open state. Through this, the battery management device 1000 may prevent the occurrence of inrush current.

Here, when the second positive contactor 210 was in an electrically short-circuited state, power is being supplied by the second battery pack 200, and thus the second positive contactor 210 should maintain the electrically short-circuited state. The second positive contactor 210 will maintain the electrically short-circuited state in response to the final signal SIG_OPFIN in a logic high state of 1, which is the previous value.

In the above, all components constituting the embodiment have been described as being combined or combined to operate as one, but it is not necessarily limited to this embodiment, and within the scope of the purpose of the invention, one or more components of all components may be selectively combined and operated. In addition, the terms "include," "compose," or "have" described above, unless specifically stated to the contrary, mean that the corresponding component can be inherent, and therefore should be interpreted as including other components rather than excluding other components.

The above description is merely an illustrative description of the technical idea disclosed in this document, and those skilled in the art in the technical field to which the embodiments disclosed in this document belong will be able to make various modifications and variations thereto without departing from the essential characteristics of the embodiments disclosed in this document.

Therefore, the embodiments disclosed in this document are not intended to limit but explain the technical idea disclosed in this document, and the scope of the technical idea disclosed in this document is not limited by these embodiments. The scope of protection of the technical idea disclosed in this document should be interpreted by the claims below, and all technical ideas within the equivalent scope should be interpreted as being included in the scope of rights of this document.

## Claims

1. A battery management device comprising:
an intermediate signal generation unit that generates an intermediate signal related to operation control of a contactor corresponding to each of a first battery pack and a second battery pack connected in parallel with the first battery pack; and
a final signal generation unit that generates a final signal for controlling an electrical connection of the contactor corresponding to the second battery pack based on a comparison result between a link voltage, which is a voltage applied to nodes to which the first battery pack and the second battery pack are connected by the first battery pack, and a pack voltage applied to a positive contactor corresponding to the second battery pack, and the intermediate signal.

2. The battery management device of claim 1, wherein the final signal generation unit includes:
a comparator that receives the link voltage and the pack voltage and generates a comparison signal; and
an SR latch that receives the comparison signal and the intermediate signal and generates the final signal.

3. The battery management device of claim 2, wherein the comparator generates a comparison signal in a logic high state when a difference between a voltage level of the link voltage and a voltage level of the pack voltage is less than a preset reference value and
generates a comparison signal in a logic low state when the difference between the voltage level of the link voltage and the voltage level of the pack voltage is greater than or equal to the preset reference value.

4. The battery management device of claim 2, wherein the SR latch receives an inverted intermediate signal through a set terminal Set and receive the comparison signal through a reset terminal Reset.

5. The battery management device of claim 4, wherein the SR latch further includes an enable terminal for receiving an enable signal related to a connection of a negative contactor corresponding to the second battery pack, and
the enable terminal receives an enable signal in a logic high state when the negative contactor corresponding to the second battery pack is in a short-circuited state and
receives a disable signal in a logic low state when the negative contactor corresponding to the second battery pack is in an open state.

6. The battery management device of claim 4, wherein the final signal corresponds to an inverted output Q' of the SR latch, and
the positive contactor corresponding to the second battery pack is electrically connected in response to the final signal in a logic high state and the intermediate signal in a logic high state.

7. A battery system comprising:
a first battery pack electrically connected to a first node based on a state of a first contactor and electrically connected to a second node based on a state of a second contactor;
a second battery pack electrically connected to the first node based on a state of a third contactor and electrically connected to the second node based on a state of a fourth contactor; and
a battery management device that controls an operation of the third contactor based on a comparison result between a link voltage applied between the first node and the second node and a pack voltage applied between the third contactor and the second node, in a state where the first battery pack is electrically connected to the first node and the second node and the second battery pack is electrically connected to the second node.

8. The battery system of claim 7, wherein the battery management device includes:
a comparator that receives the link voltage and the pack voltage; and
an SR latch that receives an output of the comparator to a reset terminal Reset and receives an intermediate signal related to operation control of the third contactor in an inverted state to a set terminal Set.

9. The battery system of claim 8, wherein the comparator outputs a comparison signal in a logic high state when a difference between a voltage level of the link voltage and a voltage level of the pack voltage is less than a preset reference value, and
outputs a comparison signal in a logic high state when a difference between the voltage level of the link voltage and the voltage level of the pack voltage is greater than or equal to the preset reference value.

10. The battery system of claim 8, wherein the battery management device further includes an AND gate that receives the intermediate signal and an inverted output Q' of the SR latch, and
electrically connects the third contactor based on an output of in a logic high state of the AND gate.

11. The battery system of claim 8, wherein the intermediate signal corresponds to a logic high state in a case of instructing the third contactor to be short-circuited, and
corresponds to a logic low state in a case of instructing the third contactor to be opened.
